# EUROPEAN PATENT APPLICATION

(11) **EP 2 317 546 A1**
(43) Date of publication of application: **04.05.2011**
(21) Application number: 09174710.5
(22) Date of filing: 30.10.2009
(51) Int. Cl.: H01L 21/683, H01L 21/687

(54) **Method of making a support structure**

(71) Applicant: Nederlandse Organisatie voor Toegepast -Natuurwetenschappelijk Onderzoek TNO, 2628 VK Delft (NL)
(72) Inventor: Koster, Norbertus Benedictus, 2612 KT Delft (NL); Meijerink, Marcus Gerhardus Hendrikus, 2525 ZZ den Haag (NL); te Sligte, Edwin, 5644 ES Eindhoven (NL)
(74) Representative: Hatzmann, Martin

(57) **Abstract**

The invention relates to a method of manufacturing a support structure for supporting an article in a lithographic process, comprising: providing a substrate having an electrically conductive top layer provided on an insulator; patterning the conductive top layer to provide a patterned electrode structure; and oxidizing the conductive top layer, so as to provide a buried electrode structure having an insulating top surface. In this way a simple buried structure can be provided as electrode structure to conveniently provide an electrostatic clamp. The invention additionally relates to a correspondingly manufactured support structure for supporting an article in a lithographic process.

## Description

### FIELD OF INVENTION

The invention relates to a method of manufacturing a support structure for supporting an article in a lithographic process.

### BACKGROUND

In a lithographic projection apparatus, during photolithographic processes, an article, such as a wafer or reticle is clamped on an article support structure by a clamping force, that may range from vacuum pressure forces, electrostatic forces, intermolecular binding forces or just gravity force. The article support defines a plane, in the form of a plurality of protrusions defining an even flat surface on which the wafer or reticle is held. Tiny variations in the height of these protrusions are detrimental to image resolution, since a small deflection of the article from an ideal plane orientation may result in rotation of the wafer and a resulting overlay error due to this rotation. In addition, such height variations of the article support may result in height variation of the article that is supported thereby. During the lithographic process, such height variations may affect image resolution due to a limited focal distance of the projection system. Therefore it is very critical to have an ideal flat article support.

European patent application EP0947884 describes a lithographic apparatus having a substrate holder wherein protrusions are arranged to improve the flatness of the substrate. For example, a general diameter of such protrusions is 0.5 mm and they may be located typically at a distance of 3 mm away from each other and thereby form a bed of supporting members that support the substrate. Due to the relative large spaces in between the protrusions, contaminations possibly present generally do not form an obstruction for the flatness of the substrate, since these will be lying in between the protrusions and will not lift the substrate locally.

Conventional manufacturing techniques are lengthy and involved with polishing steps that have a high loss and low reliability. In an alternative method, WO2008/051369 discloses a manufacturing method for an electrostatic clamp, using (pieces of) silicon wafers, which are processed and machined with CVD, PVD processes and photolithographic techniques, and consequently assembled to form an electrostatic clamp However, a challenge exists to easily provide a complete clamp consisting of a support structure having a buried electrode in an isolating structure without the need for complicated assembly techniques, because such may easily compromise the flatness of the resulting structure.

In the context of this application, the said "article" may be any of the above mentioned terms wafer, reticle, mask, or substrate, more specifically terms such as
- a substrate to be processed in manufacturing devices employing lithographic projection techniques; or
- a lithographic projection mask or mask blank in a lithographic projection apparatus, a mask handling apparatus such as mask inspection or cleaning apparatus, or a mask manufacturing apparatus or any other article or optical element that is clamped in the light path of a radiation system.
- a substrate for printing displays
- a substrate to be processed in vacuum equipment like CVD or PVD apparatus

### SUMMARY OF THE INVENTION

It is proposed to provide a method of manufacturing a support structure for supporting an article in a lithographic process, comprising:
providing a substrate having an electrically conductive top layer provided on an insulator;
patterning the conductive top layer to provide a patterned electrode structure; and
converting the conductive top layer, so as to provide a buried electrode structure having an insulating top surface that is connected to the isolator.

In another aspect, the invention relates to a support structure for supporting an article comprising:
- a substrate having an electrically conductive layer provided on an insulator;
- the conductive top layer patterned into a electrode structure; and
- said conductive layer having an oxidized top surface to form a buried electrode structure having an insulated top surface.

In this way a simple buried structure can be provided as electrode structure to conveniently provide an electrostatic clamp.

### BRIEF DESCRIPTION OF THE FIGURES

Figure 1 shows an exemplary method for manufacturing an electrostatic clamp; and
Figure 2 shows an optional provision of a burl structure on the electrostatic clamp of the Fig 1 embodiment.

### DETAILED DESCRIPTION

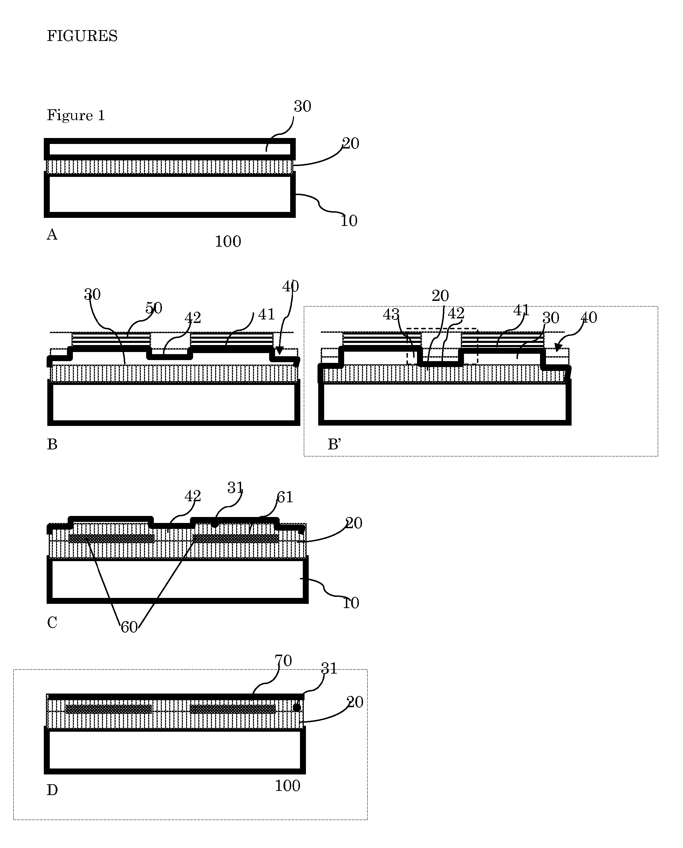

SOI (Silicon on Insulators) fabrication using buried oxide layers is well known and typically follows basic steps:
1) 02 is implanted onto the silicon substrate at a high dosage (approx. 2e18 cm-2) and energy (150-300 keV);
2) an annealing process at a high temperature (1100-1175 deg C) is done in an inert environment (e.g., using N2) for 3-5 hours, achieving two things:
   restoration of the crystallinity of the substrate surface and formation of the buried oxide itself; and
3) a layer of epitaxial silicon (which will subsequently serve as the layer over which the circuits will be built) is deposited over the buried oxide. Recently, buried silicon nitride layers (Si3N4) have likewise been successfully used in SOI technology. A Silicon on Insulator substrate 10 is shown in Figure 1.

Figure 1 shows a starting point for the inventive electrostatic clamp manufacturing method. While essentially, the method may be applicable for any type of electrostatic clamp, in particular, of the Johnson Rahbeck type wherein charge moves via a doped dielectric to the surface of the clamp, the present examples disclose an electrostatic clamp utilizing coulomb electrostatic clamping force. Essentially, the method contemplates in Step A providing a substrate 10 having an electrically conductive top layer 30 provided on an insulator 20.

Typically, such a substrate is a conductive substrate 10, of the known Silicon on Insulator type 100. Alternatively the substrate can be made from standard silicon with a passivation layer (non SOI), glass, aluminium with an anodized surface with a conductive layer of aluminium, Ti, TiN . The Silicon oxide layer 20 is an electrically insulating layer, and the Silicon top layer 30 is conductive and essentially forms the electrode material for the electrode structure to be formed. In Step B, an electrode perform 40 is etched in the conductive Silicon layer. This patterning step is provided via known methods of providing a resist layer 50, developing the resist 50; and etching the substrate to form a patterned preform electrode structure 40 corresponding to the resist pattern. Afterwards, the patterned resist layer is removed. Accordingly, in this step, a preform electrode patterning structure 40 is created defining height contours of thicker 41 and thinner material parts 42. Alternatively, as depicted in alternative step B', the preform patterning structure 40 may not have thinner material parts 42 altogether, by exposing the insulator layer 20. In the conversion, the sides 43 of thicker parts 41 of the conductive layer 30 become isolating, in particular, by thermal conversion of Silicon into Silicon dioxide..

In Step C the conductive layer 30 is partially converted into an isolator. In particular, top layer 31 of the preform electrode structure 40 is converted into an isolator. In particular the thinner parts 42 of the conductive structure 30 are converted into an isolator, thereby isolating a thus formed electrode 61. The converted thinner parts 42 contact the lower isolating layer 20 and thereby essentially isolating the thus formed electrode structure 60. Accordingly, by oxidizing the conductive top layer 31 a buried electrode structure 60 is provided having an insulating top surface 31 that is connected to the isolator 20. Thus the top layer 31, in this manner, wholly surrounds the conductive electrode parts 61. Typically, oxidization is performed by a thermal oxidization process. It is noted that the preform, by the conversion step, is now formed in an electrode structure 60 buried in the isolator 20, 31. Other conversion methods are also possible like: wet oxidizing in case of aluminium or oxygen plasma treatment in case of Ti, SiN or TiN

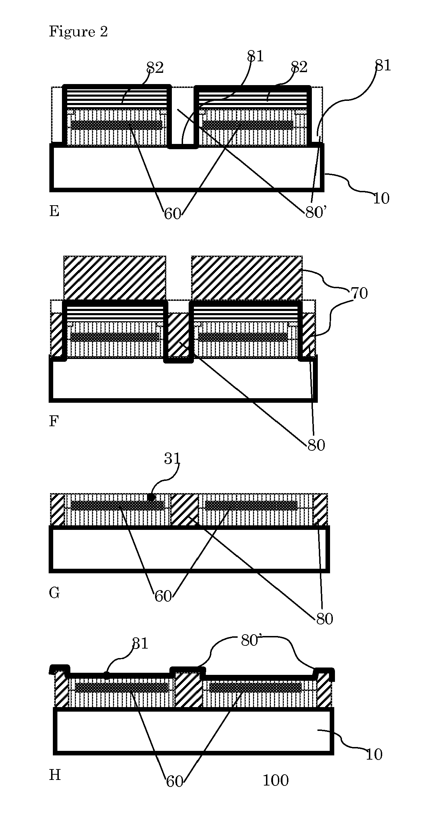

In a subsequent Step D an optional finishing step may be provided, for example, polishing, providing a wear resistant top layer 70 and/ or preparation for subsequent processing steps as shown in Figure 2. It is noted, that while the materials used are Silicon and oxidized Silicon, other materials can be contemplated such as Ge, SiN, Ti, TiN or Al in particular, the silicon layer may be doped to provide a JR type clamp or to otherwise tune the electrical conductivity of the materials as desired. Furthermore, while thermal oxidization may be a preferred oxidization method, other conversion methods may be contemplated by choosing suitable reactants.

Accordingly, it is shown in Figure 1, in particular, in Step D: a support structure 100 for supporting an article comprising:
- a substrate 10 having an electrically conductive layer 30 provided on an insulator 20;
- the conductive top layer 30 patterned into a electrode structure 40; and
- said conductive layer having an converted top surface 31 to form a buried electrode structure 40 having an insulated top surface 31.

Clearly, in operation, an electrical control system is provided (not shown) to electrically charge the electrodes to provide electrostatic clamping.

Figure 2 shows in more detail an optional process of providing a burl structure on the patterned electrode structure 60 formed as in Figure 1.

In a step E, a patterning step is provided, wherein the electrode structure is provided with vias 81. The patterning step is commonly provided using a patterned resist layer 82 that defines the via structure 80'; and a subsequent etching step to create the vias 81. Accordingly, the etching step is preferably provided to have the vias 81 contact the substrate 10 that is preferably of a conductive nature.

In step F, the etched via structure 80' is provided with a burl material 70 thus forming a burl structure 80; typically by a suitable deposition method. TiN or Silicon dioxide are optional materials with a suitable wear resistance. By choosing an electrically conductive burl material, an electrical conduction can be provided to direct electrical charge build up from a wafer to ground potential. It is noted that the burl structure 80 is electrically isolated from the electrode structure 60.

In step G, by lift -off and polishing, the top is removed to expose the insulating top surface 31 of the electrode structure.
Accordingly, the burl structure 80 is provided as a wear resistant layer 70 that is provided on the oxidized conductive top layer, wherein the resistant layer is partially removed to form the burl structure.

Additionally the burl structure is flattened to expose the insulating top surface.
Additionally, in step H, the insulating top surface 31 is etched to create a burl structure 80' protruding from the insulating top surface 31.
Accordingly, it is shown in Figure 2 in particular, step H, a support structure further comprising a burl structure 80 on the patterned electrode structure 40; the burl structure 80 provided provided with vias 81 to have the burl structure 80 contact the substrate10.

While the burl structure 80 disclosed in Figure 2 has a via structure 80' electrically contacting a conductive substrate 10 to form a grounded contact, in some embodiments this is not desired. Therefore, the burl structure 80 may also be provided isolated from the substrate 10, typically by a structure provided on top of the electrode structure. Referring to alternative step B' the burl structure may alternatively be provided in between the electrodes when the thin layer 42 is not used and the gap formed in between the electrodes 61 can be filled with a suitable burl material thus creating contact with the substrate 10.

While the invention has been illustrated and described in detail in the drawings and foregoing description, such illustration and description are to be considered illustrative or exemplary and not restrictive; the invention is not limited to the disclosed embodiments. In particular, unless clear from context, aspects of various embodiments that are treated in various embodiments separately discussed are deemed disclosed in any combination variation of relevance and physically possible and the scope of the invention extends to such combinations.

The skilled artisan will appreciate that, in the context of such alternative applications, any use of the terms "wafer" herein may be considered as synonymous with the more general term "substrate".

Other variations to the disclosed embodiments can be understood and by those skilled in the art in practicing the claimed invention, from a study of the drawings, the disclosure, and the appended claims. It is proposed to provide a method of manufacturing a support structure for supporting an article in a lithographic process, comprising:
providing a substrate having an electrically conductive top layer provided on an insulator;
patterning the conductive top layer to provide a patterned electrode structure; and
converting the conductive top layer, so as to provide a buried electrode structure having an insulating top surface that is connected to the isolator.

In another aspect, the invention relates to a support structure for supporting an article comprising:
a substrate having an electrically conductive layer provided on an insulator;
the conductive top layer patterned into a electrode structure; and
a top layer on the said patterned electrode structure to form a buried electrode structure having an insulated top surface. Such a top layer may especially be an oxidized top surface on the said electrode structure if this is silicon.

Alternatively the electrodes may be formed of any conducting material such as metals that can be photostructured. In that case the top insulating layer may for example be PECVD Silicon nitride or any other thin film material.

In such cases the isolation toplayer may be deposited by any other means such as for example CVD, PECVD, spin-coating. Materials can be for example silicon-oxide, silicon-nitride, polymers or any other isolating layers that can be deposited in a thin and homogeneous way. In the claims, the word "comprising" does not exclude other elements or steps, and the indefinite article "a" or "an" does not exclude a plurality. A single unit may fulfill the functions of several items recited in the claims. The mere fact that certain measures are recited in mutually different dependent claims does not indicate that a combination of these measured cannot be used to advantage. Any reference signs in the claims should not be construed as limiting the scope.

## Claims

1. A method of manufacturing a support structure (100) for supporting an article in a lithographic process, comprising:
- providing a substrate (10) having an electrically conductive top layer (30) provided on an insulator (20);
- patterning the conductive top layer (30) to provide a patterned electrode structure (40); and
- partially converting the conductive top layer (30), so as to provide a buried electrode structure (60) having an insulating top surface (31) that is connected to the isolator (20).

2. A method according to claim 1, wherein the electrically conductive top layer is formed by a Silicon layer (30) or any of the group of Ge, Ti, Al SiN or TiN.

3. A method according to claim 2, wherein the conductive layer is doped.

4. A method according to claim 1, wherein the conversion step is formed by thermal oxidizing or plasma treatment.

5. A method according to claim 1, wherein the insulator comprises a Silicon oxide layer (20) provided on a Silicon substrate (10).

6. A method according to claim 1, further comprising the step of providing a burl structure (80) on the patterned electrode structure (40).

7. A method according to claim 6, wherein the burl structure (80) is provided as a wear resistant layer (70) that is provided on any of the oxidized conductive top layer (31) or insulator (20), and wherein the resistant layer (70) is partially removed to form the burl structure (80).

8. A method according to claim 7, further comprising flattening the burl structure (80) to expose the insulating top surface (31); and etching the insulating top surface (31), thereby creating a burl structure (80) protruding from the insulating top surface (31).

9. A method according to claim 6, wherein, prior to provision of the wear resistant layer (70), the electrode structure (40) is provided with vias (81) to have the burl structure (80) contact any of the substrate (10) or insulator (20).

10. A method according to claim 9, wherein the burl structure (80) and the substrate (10) are electrically conductive.

11. A method according to claim 10, wherein the substrate (10) is formed of Si or Al.

12. A method according to claim 7, wherein the wear resistant layer (70) comprises TiN or Si02.

13. A support structure (100) for supporting an article comprising:
- a substrate (10) having an electrically conductive layer (30) provided on an insulator (20);
- the conductive top layer (30) patterned into a electrode structure (40); and
- said conductive layer having an converted top surface (31) to form a buried electrode structure (40) having an insulated top surface (31).

14. A support structure according to claim (13), further comprising a burl structure (80) on the patterned electrode structure (40); the burl structure (80) provided with vias (81) to have the burl structure (80) contact the substrate (10).
